(19) Europäisches Patentamt
European Patent Office
Office européen des brevets

(11) **EP 2 982 946 A1**

(12) **EUROPEAN PATENT APPLICATION**

(43) Date of publication:
**10.02.2016 Bulletin 2016/06**

(51) Int Cl.:
*G01J 1/42* (2006.01)     *G01J 9/00* (2006.01)
*G01M 11/02* (2006.01)     *G03F 7/20* (2006.01)

(21) Application number: **15002338.0**

(22) Date of filing: **05.08.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **08.08.2014 JP 2014161973**

(71) Applicant: **Canon Kabushiki Kaisha Tokyo (JP)**

(72) Inventor: **Furukawa, Yasunori Tokyo (JP)**

(74) Representative: **WESER & Kollegen Radeckestraße 43 81245 München (DE)**

(54) **LIGHT SPOT CENTROID POSITION ACQUISITION METHOD FOR WAVEFRONT SENSOR**

(57)    The method enables acquiring centroid positions of light spots formed on an optical detector (2) by multiple microlenses (1a) arranged mutually coplanarly in a wavefront sensor (3). The method includes a first step (A-3) of estimating, by using known centroid positions or known intensity peak positions of first and second light spots (a, b) respectively formed by first and second microlenses (A, B) in the multiple microlenses, a position of a third light spot (c) formed by a third microlens (C), a second step (A-4) of setting, by using the estimated position of the third light spot (c), a calculation target area for a centroid position of the third light spot on the optical detector, and a third step (A-5) of calculating the centroid position of the third light spot in the calculation target area.

FIG. 4

**EP 2 982 946 A1**

## Description

BACKGROUND OF THE INVENTION

Field of the Invention

The present invention relates to a method of acquiring centroid positions of light spots in a wavefront sensor to be used to measure a wavefront of light.

Description of the Related Art

Wavefront sensors include ones, such as a Shack-Hartmann sensor, which are constituted by a microlens array and an optical detector. Each of such wavefront sensors divides and condenses a wavefront (i.e., a phase distribution) of an entering light by multiple microlenses constituting the microlens array to capture an image of the wavefront as an image of the arrayed light spots. A calculation (measurement) can be made of wavefront aberration from a positional shift amount of the light spots shown by light intensity data acquired by the image capturing. Moreover, using such a wavefront sensor enables measuring even a wavefront having a large aberration, which enables measuring a shape of an aspheric surface as well.

However, accurately measuring the wavefront having the large aberration requires accurately acquiring centroid positions of the light spots formed by the microlenses. Japanese Patent Laid-Open No. 2010-185803 discloses a method of previously setting, for each microlens, an area of CCD data in which the centroid position of the light spot is calculated. On the other hand, Japanese Translation of PCT International Application Publication No. JP-T-2002-535608 discloses a method of setting an area in which a centroid position of a specific light spot is calculated by using a position of a light spot adjacent to the specific light spot and of calculating the centroid position in the area.

However, an increase in the wavefront aberration of the light entering the wavefront sensor increases the positional shift amounts of the light spots formed by the microlenses, which makes the centroid positions of the light spots located outside the area set by each of the methods respectively disclosed in Japanese Patent Laid-Open No. 2010-185803 and Japanese Translation of PCT International Application Publication No. JP-T-2002-535608. Consequently, the result of the centroid position calculation has an error, making it impossible to measure the wavefront with good accuracy.

SUMMARY OF THE INVENTION

The present invention provides a light spot centroid position acquisition method and others, each being a capable of accurately calculating centroid positions of light spots formed by microlenses even when a wavefront or a wavefront aberration of light entering a wavefront sensor is large. The present invention further provides a wavefront measurement method and a wavefront measurement method apparatus each using the light spot centroid position acquisition method.

The present invention in its first aspect provides a light spot centroid position acquisition method as specified in claims 1 to 4.

The present invention in its second aspect provides a wavefront measurement method as specified in claim 5.

The present invention in its third aspect provides a wavefront measurement apparatus as specified in claim 6.

The present invention in its fourth aspect provides a method of manufacturing an optical element as specified in claim 7.

The present invention in its fifth aspect provides a light spot centroid position acquisition program as specified in claim 8.

Further features of the present invention will become apparent from the following description of exemplary embodiments with reference to the attached drawings.

BRIEF DESCRIPTION OF THE DRAWINGS

FIG. 1 illustrates a configuration of a wavefront sensor to which a light spot centroid position acquisition method that is Embodiment 1 of the present invention is applied.

FIG. 2 illustrates a calculation target area of a centroid position of a specific light spot acquired from a centroid position of one light spot.

FIG. 3 illustrates the calculation target area of the centroid position of the specific light spot acquired from centroid positions of two light spots by using the light spot centroid position acquisition method of Embodiment 1.
FIG. 4 is a flowchart illustrating a procedure of the light spot centroid position acquisition method of Embodiment 1.
FIG. 5 illustrates a microlens array for which the centroid positions of the light spots are calculated by using the light spot centroid position acquisition method of Embodiment 1.
FIG. 6 illustrates Embodiment 2 of the present invention.
FIG. 7 illustrates a configuration of a wavefront measurement apparatus to which a wavefront measurement method that is Embodiment 3 of the present invention is applied.

DESCRIPTION OF THE EMBODIMENTS

Exemplary embodiments of the present invention will be described below with reference to the attached drawings.

[Embodiment 1]

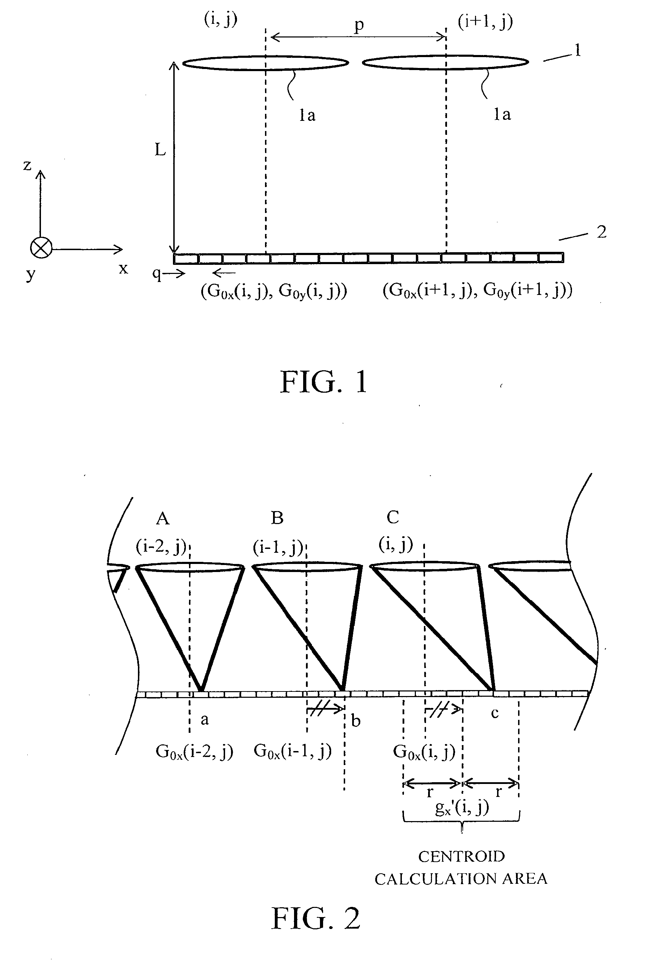

FIG. 1 illustrates a configuration of a wavefront sensor 3 to which a light spot centroid position acquisition method that is a first embodiment (Embodiment 1) of the present invention is applied. Description will hereinafter be made of each constituent element of the wavefront sensor 3 by using an xyz orthogonal coordinate system set as illustrated in FIG. 1. In FIG. 1, (i,j) represents a position of a microlens in a two-dimensional arrangement in x and y directions, with symbols i and j indicating a row and a column, respectively.
In FIG. 1, reference numeral 1 denotes a microlens array, and 2 denotes a two-dimensional optical detector such as, typically, a CCD image sensor (the optical detector 2 is hereinafter referred to as "a CCD"). The microlens array 1 is constituted by multiple microlenses 1a two-dimensionally arranged on an x-y plane (that is, arranged mutually coplanarly). The x-y plane is a plane orthogonal to an optical axis direction (a z direction) of each microlens 1a. The multiple microlenses 1a divide an entering light into multiple light fluxes. Each microlens 1a condenses the divided light flux to cause it to form a light spot on the CCD 2. Consequently, the same number (multiple) of light spots as that of the microlenses 1a are formed on the CCD 2.
In FIG. 1, L represents a distance between the microlens array 1 and the CCD 2 in the z direction. Similarly, p represents a pitch (hereinafter referred to as "a microlens pitch") between the microlenses 1a mutually adjacent in the microlens array in an x direction (and a y direction), and q represents a pixel pitch of the CCD 2. In addition, I represents an intensity of the light spot on the CCD 2, and $(G_{0x}, G_{0y})$ represents a centroid position of the light spot on the CCD 2 corresponding to when a light with a plane wavefront (the light is hereinafter referred to as "a plane wavefront light") enters the microlens 1a. Furthermore, W(x,y) represents a wavefront of the light entering the wavefront sensor 3.
FIG. 2 illustrates three microlenses (a first microlens, a second microlens and a third microlens) A, B and C arranged in the x direction in the microlens array. Positions of the microlenses A, B and C in the microlens array are (i-2,j), (i-1,j) and (i,j), respectively, which are respectively represented by xy coordinates (x-p,y), (x,y) and (x+p,y). In this case, centroid positions of light spots (a first light spot, a second light spot and a third light spot) a, b and c respectively formed by the microlenses A, B and C on the CCD 2 when the plane wavefront light enters the wavefront sensor 3 are expressed by expression (1) where i represents an integer equal to or more than 3 and equal to or less than number of the microlenses in the x direction, and j represents an integer equal to or more than 1 and equal to or less than the number of the microlenses in the y direction.

$$G_{0x}(i-2,j) = \frac{x-p}{q}, G_{0y}(i-2,j) = \frac{y}{q}$$

$$G_{0x}(i-1,j) = \frac{x}{q}, G_{0y}(i-1,j) = \frac{y}{q} \qquad (1)$$

$$G_{0x}(i,j) = \frac{x-p}{q}, G_{0y}(i,j) = \frac{y}{q}$$

In this embodiment, with an assumption that the centroid positions $(G_x(i-2,j), G_y(i-2,j))$ and $(G_x(i-1,j), G_y(i-1,j))$ of the light spots a and b are known, the centroid position $(G_x(i,j), G_y(i,j))$ of the light spot c is acquired as described below.
The centroid position $(G_{0x}(i,j), G_{0y}(i,j))$ of the light spot corresponding to when the plane wavefront light enters the microlens 1a which is expressed by expression (1) is rounded to an integer value $(g_{0x}(i,j), g_{0y}(i,j))$ by using a definition expressed by expression (2) where round() represents a function to round the number in the parentheses to an integer closest to the number.

$$g_{0x}(i, j) = round(G_{0x}(i, j))$$
$$g_{0y}(i, j) = round(G_{0y}(i, j)) \qquad (2)$$

In this case, the centroid position $(G_x(i,j),G_y(i,j))$ of the light spot formed by the light (wavefront) entering one microlens is acquired by expression (3).

$$G_x(i, j) = g_{0x}(i, j) + \frac{\sum_{s=-r}^{r} \sum_{t=-r}^{r} s \times I(g_{0x}(i, j) + s, g_{0y}(i, j) + t)^n}{\sum_{s=-r}^{r} \sum_{t=-r}^{r} I(g_{0x}(i, j) + s, g_{0y}(i, j) + t)^n} \qquad (3)$$

$$G_y(i, j) = g_{0y}(i, j) + \frac{\sum_{s=-r}^{r} \sum_{t=-r}^{r} t \times I(g_{0x}(i, j) + s, g_{0y}(i, j) + t)^n}{\sum_{s=-r}^{r} \sum_{t=-r}^{r} I(g_{0x}(i, j) + s, g_{0y}(i, j) + t)^n}$$

In expression (3), I(s,t) represents a light intensity at a pixel in the CCD 2 located in a column s and a row t. Symbol n represents a positive real number having a value of approximately 1 to 3. A value 2r+1 represents number of pixels along each of sides included in a calculation target area (hereinafter referred to as "a centroid calculation area") on the CCD 2 where the centroid position of the light spot formed by one microlens is calculated. Since the light spots formed by the other microlenses are present at positions distant by the microlens pitch p from the light spot whose centroid position is to be calculated (the light spot is hereinafter referred to also as "a target light spot"), it is desirable that r be approximately a half of the microlens pitch p, which is expressed by expression (4).

$$r = round\left(\frac{p}{2q}\right) \qquad (4)$$

In addition, since light intensity data (measurement data) acquired from the centroid calculation area on the CCD 2 contains a background noise such as a shot noise, a calculation of expression (3) may be performed after light intensity data corresponding to when the CCD 2 receives no light is subtracted from the measured data.

A wavefront W(x,y) and an angular distributions $(\psi_x(x,y)$ and $\psi_y(x,y))$ of the light entering the microlens array 1 and the centroid position $(G_x,G_y)$ of the light spot have thereamong relations expressed by expression (5).

$$\frac{dW(x, y)}{dx} = \tan(\psi_x(x, y)) = \frac{(G_x(x, y) - G_{0x}(x, y)) \times q}{L}$$
$$\frac{dW(x, y)}{dy} = \tan(\psi_y(x, y)) = \frac{(G_y(x, y) - G_{0y}(x, y)) \times q}{L} \qquad (5)$$

For this reason, the wavefront W is calculated from the intensity I as follows. First, the centroid position (Gx,Gy) of the light spot is calculated by using expression (3) for all the microlenses 1a that the plane wavefront light enters, and then the angular distribution of or a differential value of the wavefront of the light (light rays) entering the microlenses 1a is calculated by using expression (5). Next, a two-dimensional integral calculation is performed on the angular distribution of the light rays or the differential value of the wavefront. As an integral calculation method, a method described in the following literature is known: W.H.Southwell, "Wave-front estimation from wave-front slope measurement", J.Opt.Soc.Am.70, pp998-1006, 1980.

In the above-described manner, the wavefront W is calculated from the intensity I.

In the calculation method that the centroid calculation area is fixed beforehand for each microlens 1a, when the wavefront of the entering light is large, such as when the differentiated wavefront satisfies a condition of expression (6), or when an incident angle $\psi_{x,y}$ satisfies a condition of expression (7), the position of the light spot is outside the centroid calculation area, which makes it difficult to calculate the centroid position.

$$\frac{dW}{dx} > \frac{r \times q}{L}$$
$$\frac{dW}{dy} > \frac{r \times q}{L}$$

(6)

$$\psi_{x,y} > atan\left(\frac{r \times q}{L}\right)$$

(7)

On the other hand, the method disclosed in Japanese Translation of PCT International Application Publication No. JP-T-2002-535608 estimates the centroid position of the target light spot c by using the centroid position of one light spot b adjacent to the target light spot c. For instance, when a position distant by the microlens pitch p from the centroid position of the light spot b is defined as a primary estimation position $(g_x'(i,j), g_y'(i,j))$ of the target light spot c as illustrated in FIG. 2, the primary estimation position $(g_x'(i,j), g_y'(i,j))$ is expressed by expression (8).

$$g_x'(i,j) = round\{G_{0x}(i,j) + G_x(i-1,j) - G_{0x}(i-1,j)\}$$
$$= round\{G_x(i-1,j) + p/q\}$$
$$g_y'(i,j) = round\{G_{0y}(i,j) + G_y(i-1,j) - G_{0y}(i-1,j)\}$$
$$= round\{G_y(i-1,j)\}$$

(8)

From the estimated position $(g_x'(i,j), g_y'(i,j))$ of the target light spot c, the centroid calculation area is set as follows.

x direction: $g_x'(i,j)-r\sim g_x'(i,j)+r$
y direction: $g_y'(i,j)-r\sim g_y'(i,j)+r$

The centroid position of the target light spot c is calculated by expression (9).

$$G_x(i,j) = g_x'(i,j) + \frac{\sum_{s=-r}^{r} \sum_{t=-r}^{r} s \times I(g_x'(i,j)+s, g_y'(i,j)+t)^n}{\sum_{s=-r}^{r} \sum_{t=-r}^{r} I(g_x'(i,j)+s, g_y'(i,j)+t)^n}$$

(9)

$$G_y(i,j) = g_y'(i,j) + \frac{\sum_{s=-r}^{r} \sum_{t=-r}^{r} t \times I(g_x'(i,j)+s, g_y'(i,j)+t)^n}{\sum_{s=-r}^{r} \sum_{t=-r}^{r} I(g_x'(i,j)+s, g_y'(i,j)+t)^n}$$

In addition, a relation between the wavefront W and the centroid position $(G_x, G_y)$ of the light spot in the x direction is expressed by expression (10):

$$L \times \frac{dW(x,y)}{dx} = \{G_x(i-1,j) - G_{0x}(i-1,j)\}q$$

$$L \times \frac{dW(x+p,y)}{dx} = \{G_x(i,j) - G_{0x}(i,j)\}q$$

$$L \times \frac{dW(x,y)}{dy} = \{G_y(i-1,j) - G_{0y}(i-1,j)\}q$$

$$L \times \frac{dW(x+p,y)}{dy} = \{G_y(i,j) - G_{0y}(i,j)\}q \qquad (10)$$

Similarly, in the y direction, a relation between the wavefront W and the centroid position (Gx,Gy) of the light spot is expressed by expression (11).

$$L \times \frac{dW(x,y+p)}{dx} = \{G_x(i-1,j+1) - G_{0x}(i-1,j+1)\}q$$

$$L \times \frac{dW(x,y+p)}{dy} = \{G_y(i-1,j+1) - G_{0y}(i-1,j+1)\}q \qquad (11)$$

Thus, when the wavefront W satisfies a condition of expression (12) or (13), the position of the target light spot c is outside of the centroid calculation area, which makes it difficult to calculate the centroid position of the target light spot c.

$$L \times \left| \frac{dW(x+p,y)}{dx} - \frac{dW(x,y)}{dx} \right| > qr$$

$$L \times \left| \frac{dW(x+p,y)}{dy} - \frac{dW(x,y)}{dy} \right| > qr$$

$$L \times \left| \frac{dW(x,y+p)}{dx} - \frac{dW(x,y)}{dx} \right| > qr \qquad (12)$$

$$L \times \left| \frac{dW(x,y+p)}{dy} - \frac{dW(x,y)}{dy} \right| > qr$$

$$\left| \frac{d^2W(x,y)}{dx^2} \right| > \frac{qr}{pL}$$

$$\left| \frac{d^2W(x,y)}{dxdy} \right| > \frac{qr}{pL} \qquad (13)$$

$$\left| \frac{d^2W(x,y)}{dy^2} \right| > \frac{qr}{pL}$$

This embodiment sets the centroid calculation area corresponding to the light spot c formed by the microlens C, by using the known centroid positions or known intensity peak positions of the light spots a and b respectively formed by the microlenses A and B arranged on the identical x-y plane on which the microlens C is disposed. The expression "on the identical x-y plane on which the microlens C is disposed" can be rephrased as "on a straight line extending from the microlens C". Moreover, number of the light spots (that is, the microlenses forming these light spots) whose centroid positions or intensity peak positions to be used to set the centroid calculation area are known may be three or more and only has to be at least two, as described later.

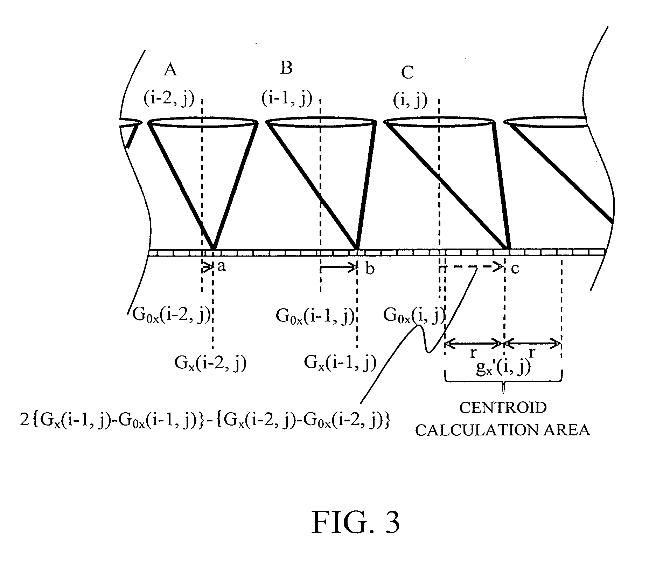

A detailed description will hereinafter be made of the method of setting the centroid calculation area. As illustrated in FIG. 3, the primary estimation position $(g_x'(i,j), g_y'(i,j))$ of the target light spot c is calculated by expression (14) by using the known centroid positions $(G_x(i-2,j), G_y(i-2,j))$ and $(G_x(i-1,j), G_y(i-1,j))$ of the light spots a and b.

$$g_x'(i,j) = \text{round}\left[G_{0x}(i,j) + 2\{G_x(i-1,j) - G_{0x}(i-1,j)\}\right.$$
$$\left. - \{G_x(i-2,j) - G_{0x}(i-2,j)\}\right]$$
$$g_y'(i,j) = \text{round}\left[G_{0y}(i,j) + 2\{G_y(i-1,j) - G_{0y}(i-1,j)\}\right. \qquad (14)$$
$$\left. - \{G_y(i-2,j) - G_{0y}(i-2,j)\}\right]$$

Also in this embodiment, the centroid calculation area is set, by using the primary estimation position $(g_x'(i,j), g_y'(i,j))$ of the target light spot c calculated by expression (14), as follows.

x direction: $g_x'(i,j)-r \sim g_x'(i,j)+r$
y direction: $g_y'(i,j)-r \sim g_y'(i,j)+r$

Expression (14) is based on an assumption that a vector from the light spot b to the target light spot c is equal to a vector v from the light spot a to the light spot b. In other words, first-order and second-order differential values of the wavefront are calculated from the known centroid positions of the two light spots a and b, and the position $(g_x'(i,j), g_y'(i,j))$ of the target light spot c is estimated by using the differential values. Thereafter, the centroid calculation area is set to a position acquired by adding the vector v to the position of the target light spot c.

For the estimation of the primary estimation position $(g_x'(i,j), g_y'(i,j))$ of the target light spot c, known intensity peak positions may be used instead of the known centroid positions of the light spots a and b.

On the other hand, in calculating the centroid position $(G_x(i,j), G_y(i,j))$ of the light spot by substituting the primary estimation position $(g_x'(i,j), g_y'(i,j))$ calculated by expression (14) into expression (9), there is a case where the centroid position $(G_x(i,j), G_y(i,j))$ satisfies a condition of expression (15) or (16). In this case, it is desirable to recalculate the primary estimation position $(g_x'(i,j), g_y'(i,j))$ by using expression (17) such that the centroid position $(G_x(i,j), G_y(i,j))$ is located at a center of the centroid calculation area and then to recalculate the centroid position $(G_x(i,j), G_y(i,j))$ by using expression (9).

$$\left|G_x(i,j) - g_x'(i,j)\right| > 0.5 \qquad (15)$$

$$\left|G_y(i,j) - g_y'(i,j)\right| > 0.5 \qquad (16)$$

$$g_x'(i,j) = \text{round}\{G_x(i,j)\}$$
$$g_y'(i,j) = \text{round}\{G_y(i,j)\} \qquad (17)$$

The centroid calculation area is not necessarily required to be a rectangular area and may alternatively be, for example, a circular area whose center is the primary estimation position $(g_x'(i,j), g_y'(i,j))$. The wavefront for which the centroid position of the light spot can be calculated by this embodiment (that is, a wavefront that can be measured; hereinafter referred to as "a measurable wavefront") is expressed by expression (18) or (19).

$$L \times \left| \left\{ \frac{dW(x+p,y)}{dx} - \frac{dW(x,y)}{dx} \right\} - \left\{ \frac{dW(x,y)}{dx} - \frac{dW(x-p,y)}{dx} \right\} \right| < qr$$

$$L \times \left| \left\{ \frac{dW(x+p,y)}{dy} - \frac{dW(x,y)}{dy} \right\} - \left\{ \frac{dW(x,y)}{dy} - \frac{dW(x-p,y)}{dy} \right\} \right| < qr \qquad (18)$$

$$L \times \left| \left\{ \frac{dW(x,y+p)}{dx} - \frac{dW(x,y)}{dx} \right\} - \left\{ \frac{dW(x,y)}{dx} - \frac{dW(x,y-p)}{dx} \right\} \right| < qr$$

$$L \times \left| \left\{ \frac{dW(x,y+p)}{dy} - \frac{dW(x,y)}{dy} \right\} - \left\{ \frac{dW(x,y)}{dy} - \frac{dW(x,y-p)}{dy} \right\} \right| < qr$$

$$\left| \frac{d^3W(x,y)}{dx^3} \right| < \frac{qr}{p^2L}$$

$$\left| \frac{d^3W(x,y)}{dx^2dy} \right| < \frac{qr}{p^2L} \qquad (19)$$

$$\left| \frac{d^3W(x,y)}{dxdy^2} \right| < \frac{qr}{p^2L}$$

$$\left| \frac{d^3W(x,y)}{dy^3} \right| < \frac{qr}{p^2L}$$

As an example, a calculation is made of a size of a measurable wavefront for which the centroid position of the light spot can be calculated by the wavefront sensor 3 having values shown by expression (20). In this calculation, the wavefront is expressed by expression (22) by using a coordinate h defined by expression (21), and the size of the wavefront is expressed by a coefficient Z.

$$\begin{aligned} p &= 0.15[\text{mm}] \\ L &= 5[\text{mm}] \\ q &= 0.007[\text{mm}] \qquad (20) \\ r &= 7 \\ R &= 5[\text{mm}] \end{aligned}$$

$$h = \sqrt{x^2 + y^2} \qquad (21)$$

$$W(h) = Z\left\{ 6\left(\frac{h}{R}\right)^4 - 6\left(\frac{h}{R}\right)^2 + 1 \right\} \qquad (22)$$

In expressions (20) and (22), R represents an analytical radius. Since it is only necessary to calculate the size of the measurable wavefront at a position where a variation of the wavefront is largest, a largest coefficient Z is calculated by regarding h as being equal to R and substituting the above values into expressions (6), (13) and (19). The coefficient Z is derived as Z=5.8[μm] from the method fixing the centroid calculation area and is derived as Z=38.9[μm] from the

method setting the centroid calculation area by using the centroid position of the one adjacent light spot.

In contrast, the method of this embodiment enables calculating a centroid position of a light spot formed by a wavefront with a largest allowable size of $Z=540[\mu m]$. That is, this embodiment enables providing a measurable wavefront having a size significantly larger as compared to those provided by conventional methods.

Although this embodiment described above the case of primarily estimating the position of the target light spot by using the known centroid positions (or the known intensity peak positions) of the two light spots, the position of the target light spot may be primarily estimated by alternatively using known centroid positions of three or more light spots. For instance, when centroid positions $(G_x(i-3,j),G_y(i-3,j))$, $(G_x(i-2,j),G_y(i-2,j))$ and $(G_x(i-1,j),G_y(i-1,j))$ of light spots formed by three microlenses whose positions are (i-3,j), (i-2,j) and (i-1,j) are known, the primary estimation position $(g_x'(i,j),g_y'(i,j))$ of the target light spot formed by the microlens whose position is (i,j) is estimated by using expression (23).

$$
\begin{aligned}
g_x'(i,j) = \mathrm{round}\big[ &G_{0x}(i,j) + 3\{G_x(i-1,j) - G_{0x}(i-1,j)\} \\
&-3\{G_x(i-2,j) - G_{0x}(i-2,j)\} + \{G_x(i-3,j) - G_{0x}(i-3,j)\}\big] \\
g_y'(i,j) = \mathrm{round}\big[ &G_{0y}(i,j) + 3\{G_y(i-1,j) - G_{0y}(i-1,j)\} \\
&-3\{G_y(i-2,j) - G_{0y}(i-2,j)\} + \{G_y(i-3,j) - G_{0y}(i-3,j)\}\big]
\end{aligned}
\qquad (23)
$$

In this estimation, the measurable wavefront for which the centroid position of the target light spot can be calculated is expressed by expression (24).

$$
\begin{aligned}
\left| \frac{d^4 W(x,y)}{dx^4} \right| &< \frac{qr}{p^3 L} \\[2mm]
\left| \frac{d^4 W(x,y)}{dx^3 dy} \right| &< \frac{qr}{p^3 L} \\[2mm]
\left| \frac{d^4 W(x,y)}{dx dy^3} \right| &< \frac{qr}{p^3 L} \\[2mm]
\left| \frac{d^4 W(x,y)}{dy^4} \right| &< \frac{qr}{p^3 L}
\end{aligned}
\qquad (24)
$$

The microlenses forming the light spots whose centroid positions (or the intensity peak positions) are known are not necessarily required to be adjacent to the microlens (hereinafter referred to also as "a target microlens") forming the target light spot. The centroid position of the target light spot may be primarily estimated by using known centroid positions of any light spots formed by the microlenses arranged coplanarly (or collinearly) with the target microlens.

For instance, when (i-2,j) and (i-4,j) represent positions of two microlenses arranged on an identical straight line y=j on which the target microlens whose position is (i,j) is disposed, the primary estimation position $(g_x'(i,j),g_y'(i,j))$ of the target light spot may be acquired by using known centroid positions $(G_x(i-2,j),G_y(i-2,j))$ and $(G_x(i-4,j),Gy(i-4,j))$ of the light spots formed by the two microlenses and expression (25).

$$
\begin{aligned}
g_x'(i,j) = \mathrm{round}\big[ &G_{0x}(i,j) + 2\{G_x(i-2,j) - G_{0x}(i-2,j)\} \\
&-\{G_x(i-4,j) - G_{0x}(i-4,j)\}\big] \\
g_y'(i,j) = \mathrm{round}\big[ &G_{0y}(i,j) + 2\{G_y(i-2,j) - G_{0y}(i-2,j)\} \\
&-\{G_y(i-4,j) - G_{0y}(i-4,j)\}\big]
\end{aligned}
\qquad (25)
$$

Alternatively, when (i-1,j-1) and (i-2,j-2) represent positions of two microlenses arranged on a straight line y=x-i+j, the primary estimation position $(g_x'(i,j),g_y'(i,j))$ may be calculated, by using known centroid positions $(G_x(i-1,j-1),G_y(i-1,j-1))$ and $(G_x(i-2,j-2),G_y(i-2,j-2))$ of light spots formed by the two microlenses and expression (26):

$$g_x{}'(i, j) = \text{round}\big[G_{0x}(i, j) + 2\{G_x(i-1, j-1) - G_{0x}(i-1, j-1)\}$$
$$-\{G_x(i-2, j-2) - G_{0x}(i-2, j-2)\}\big]$$
$$g_y{}'(i, j) = \text{round}\big[G_{0y}(i, j) + 2\{G_y(i-1, j-1) - G_{0y}(i-1, j-1)\}$$
$$-\{G_y(i-2, j-2) - G_{0y}(i-2, j-2)\}\big] \tag{26}$$

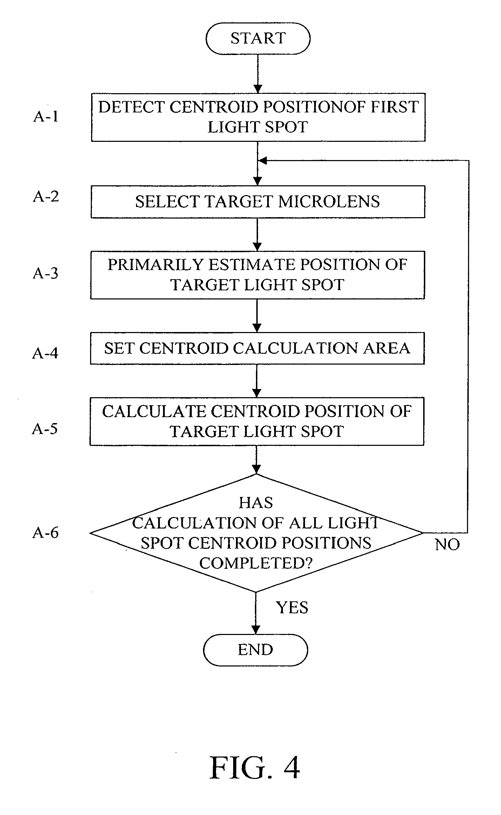

Next, with reference to a flowchart of FIG. 4, description will be made of a process to calculate, by using the above-described light spot centroid position acquisition method of this embodiment, centroid positions of light spots formed by all the microlenses of the wavefront sensor 3 that the light enters. This process is performed by a computer such as a personal computer according to a light spot centroid position acquisition program that is a computer program.

At step A-1, the computer selects one light spot for which the computer calculates its centroid position first of all and then calculates that centroid position. As the first light spot, the computer can select one light spot located near a centroid of an intensity distribution of the light entering the wavefront sensor 3 or near a center of the CCD 2.

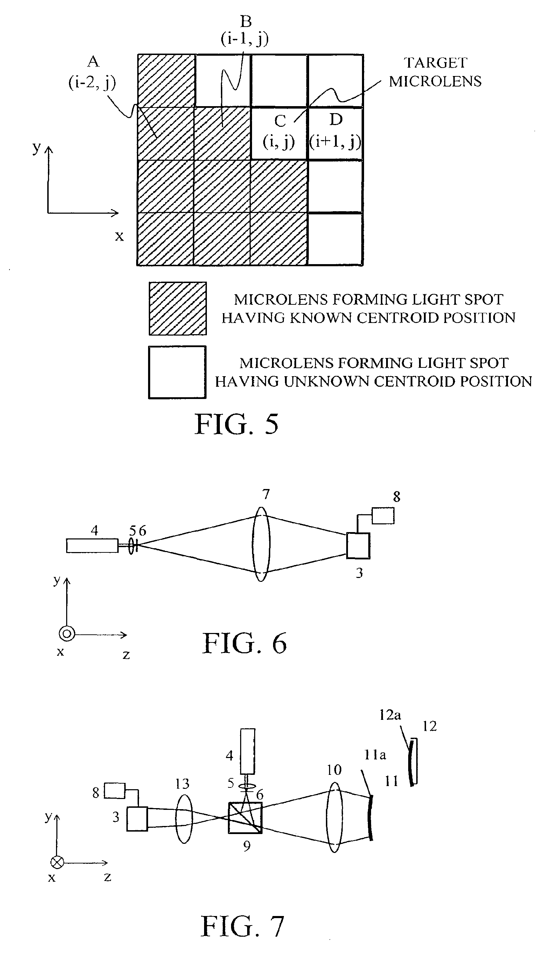

Next, at step A-2, the computer selects, from all the microlenses, a target microlens for which the computer calculates its centroid position by using the above-described light spot centroid position acquisition method. As illustrated in FIG. 5, the computer selects a microlens adjacent to microlenses (hatched in FIG. 5) forming light spots whose centroid positions are known as the target microlens C(i,j). In addition, the computer provides beforehand a flag formed by a matrix which corresponds to a two-dimensional arrangement of all the microlenses and whose elements each have a value of 0, and changes the value of the flag (i,j) to 1 in response to an end of the calculation of the centroid position of the target light spot formed by the target microlens C(i,j). This flag enables determining whether or not the target microlens C(i,j) is one for which the computer has already calculated the centroid position of the light spot. Alternatively, the computer may select the target microlens depending on the flag.

Next, at step A-3 (a first step), the computer selects, as illustrated in FIG. 5, two microlenses A(i-2,j) and B(i-1,j) arranged coplanarly (collinearly) with the target microlens C. Thereafter, the computer primarily estimates a position $(g_x{}'(i,j), g_y{}'(i,j))$ of the target light spot with expression (14) by using the known centroid positions of the two light spots formed by these two microlenses A(i-2,j) and B(i-1,j). When there is only one light spot whose centroid position is known, the position of the target light spot can be primarily estimated by using expression (8) or by increasing a value of r that defines a size of the above-described centroid calculation area.

Next, at step A-4 (a second step), the computer sets the centroid calculation area by using the primary estimation position $(g_x{}'(i,j), g_y{}'(i,j))$ of the target light spot. When the wavefront to be measured is a divergent wavefront, the value of r representing the size of the centroid calculation area may be set to a value expressed by expression (4) since an interval between the light spots mutually adjacent is long. On the other hand, when the wavefront to be measured is a convergent wavefront, since the interval between the mutually adjacent light spots is short, it is desirable, for example, to calculate an interval between the known centroid positions of the two light spots and to set the value of r to a half of the calculated interval.

Subsequently, at step A-5 (a third step), the computer calculates the centroid position of the target light spot with expression (9) by using the primary estimation position $(g_x{}'(i,j), g_y{}'(i,j))$ of the target light spot and the value of r.

When the centroid position of the target light spot calculated at this step satisfies the condition of expression (15) or (16), the computer may return to step A-4 to set a new centroid calculation area such that the centroid position of the target light spot is located at a center of the newly set centroid calculation area. In this case, the computer recalculates the centroid position of the target light spot in the newly set centroid calculation area.

Thereafter, at step A-6, the computer determines whether or not the calculation of the centroid positions of all the light spots formed by all the microlenses has been completed. If not completed, the computer returns to step A-2. If completed, the computer ends this process. After returning to step A-2, the computer selects, as a new target microlens, a microlens D(i+1,j) adjacent to the target microlens C for which the calculation of the centroid position of the target light spot has been completed. Then, the computer calculates a centroid position of a target light spot formed by the target microlens D. In this manner, the computer sequentially calculates the centroid position of the target light spot for all the microlenses.

The above-described light spot centroid position acquisition method enables accurately calculating the centroid positions of all the light spots formed by all the microlenses even when the wavefront (or the wavefront aberration) of the light entering the wavefront sensor 3 is large. Moreover, this method performs neither a calculation process searching for an intensity peak position of the light received by the CCD 2 nor a repetitive calculation process including backtracking and therefore enables calculating the centroid positions of all of the light spots at high speed.

The light spot centroid position acquisition method described in this embodiment can be applied not only to a case of using a Shack-Hartmann sensor as the wavefront sensor, but also to a case of using a wavefront sensor constituted by a Shack-Hartmann plate provided with multiple microlenses and a CCD sensor.

[Embodiment 2]

FIG. 6 illustrates a configuration of a wavefront measurement apparatus that is a second embodiment (Embodiment 2) of the present invention. This wavefront measurement apparatus performs a wavefront measurement method including the light spot centroid position acquisition method described in Embodiment 1.

In FIG. 6, reference numeral 4 denotes a light source, 5 a condenser lens, 6 a pinhole, 7 a measurement object lens, 3 a wavefront sensor, and 8 an analytical calculator.

Light from the light source 4 is condensed by the condenser lens 5 toward the pinhole 6. A spherical wavefront exiting from the pinhole 6 enters the measurement object lens 7. The light (wavefront) transmitted through the measurement object lens 7 is measured by the wavefront sensor 3.

As the light source 4, a single-color laser, a laser diode or a light-emitting diode is used. The pinhole 6 is formed with an aim to produce a spherical wavefront with less aberration and therefore may be constituted alternatively by a single-mode fiber.

As the wavefront sensor 3, a Shack-Hartmann sensor or a light-receiving sensor constituted by a Shack-Hartmann plate provided with multiple microlenses and a CCD sensor.

Data (light intensity data) on the wavefront measured by the wavefront sensor 3 is input to the analytical calculator 8. The analytical calculator 8, which is constituted by a personal computer, calculates centroid positions of all of light spots formed on the wavefront sensor 3 according to the light spot centroid position acquisition program described in Embodiment 1 and further calculates the wavefront by using the calculated centroid positions of all the light spots. This calculation enables acquiring aberration of the measurement object lens 7.

[Embodiment 3]

FIG. 7 illustrates a configuration of a wavefront measurement apparatus that is a third embodiment (Embodiment 3) of the present invention. This wavefront measurement apparatus is also an apparatus that performs a wavefront measurement method including the light spot centroid position acquisition method described in Embodiment 1.

In FIG. 7, reference numeral 4 denotes a light source, 5 a condenser lens, 6 a pinhole, 9 a half mirror, 10 a projection lens and 11 a reference lens. Reference numeral 11a denotes a reference surface that is one of both surfaces of the reference lens 11. Reference numeral 12 denotes a measurement object lens (an optical element), and 12a a measurement object surface that is one of both surfaces of the measurement object lens. Reference numeral 13 denotes an imaging lens, 3 a wavefront sensor, and 8 an analytical calculator.

Light from the light source 4 is condensed by the condenser lens 5 toward the pinhole 6. A spherical wavefront exiting from the pinhole 6 is reflected by the half mirror 9 and then converted by the projection lens 10 into a convergent light. The convergent light is reflected by the reference surface 11a or the measurement object surface 12a, transmitted through the projection lens 10, the half mirror 9 and the imaging lens 13 and then enters the wavefront sensor 3.

When the reference surface 11a of the reference lens 11 or the measurement object surface 12a of the measurement object lens 12 is an aspheric surface, the wavefront of the light entering the wavefront sensor 3 is large.

In order to calibrate optical systems such as the projection lens 10 and the imaging lens 13, this embodiment measures the reference surface 11a having a known surface shape to calculate a shape of the measurement object surface 12a from a difference between the known surface shape of the reference surface 11a and the measurement result of the measurement object surface 12a.

Description will be made of a method of manufacturing the measurement object lens 12, the method including the measurement of the measurement object surface 12a. First, the wavefront sensor 3 receives the light reflected by each of the reference surface 11a and the object surface 12a. Next, the analytical calculator 8 calculates, from light intensity data acquired from the wavefront sensor 3, centroid positions of all light spots according to the light spot centroid position acquisition program described in Embodiment 1.

Then, the analytical calculator 8 calculates, by using the calculated centroid positions of all the light spots, an angular distribution $(S_{bx}, S_{by})$ of the reference surface 11a and an angular distribution $(S_x, S_y)$ of the measurement object surface 12a.

Next, the analytical calculator 8 converts a position $(x,y)$ of each microlens of the wavefront sensor 3 into coordinates $(X,Y)$ on the reference surface 11a. In addition, the analytical calculator 8 converts the angular distribution $(S_x, S_y)$ of the measurement object surface 12a and the angular distribution $(S_{bx}, S_{by})$ of the reference surface 11a respectively into angular distributions $(S_x', S_y')$ and $(S_{bx}', S_{by}')$ on the reference surface 11a.

Thereafter, the analytical calculator 8 calculates a shape difference between the reference surface 11a and the measurement object surface 12a by using a difference between the angular distributions $(S_x'-S_{bx}', S_y'-S_{by}')$ and by using the coordinates $(X,Y)$. The shape (actual shape) of the measurement object surface 12a can be calculated by adding the shape of the reference surface 11a to the shape difference.

From a difference between the actual shape of the object surface 12a thus calculated (measured) and a target shape thereof, lateral coordinates and shape correction amounts for shaping the measurement object lens 12 are calculated. Then, a shaping apparatus (not illustrated) shapes the measurement object surface 12a. This series of processes enables providing a target lens (measurement object lens) 12 whose surface 12a has the target shape.

The above embodiments enable calculating, at high speed and with good accuracy, the centroid positions of the light spots formed by the microlenses even when the wavefront of the light entering the wavefront sensor or the wavefront aberration of the light is large. This enables performing wavefront measurement using the wavefront sensor at high speed and with good accuracy.

Other Embodiments

Embodiment(s) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

**Claims**

1. A light spot centroid position acquisition method of acquiring a centroid position of each of light spots formed on an optical detector (2) by multiple microlenses (1a) arranged mutually coplanarly in a wavefront sensor (3) to be used to measure a wavefront of light, the method **characterized by** comprising:

   a first step (A-3) of estimating, by using known centroid positions or known intensity peak positions of a first light spot (a) and a second light spot (b) respectively formed by a first microlens (A) and a second microlens (B) in the multiple microlenses, a position of a third light spot (c) formed by a third microlens (C) in the multiple microlenses, the first to third microlenses being collinearly arranged;
   a second step (A-4) of setting, by using the estimated position of the third light spot (c), a calculation target area of a centroid position of the third light spot on the optical detector; and
   a third step (A-5) of calculating the centroid position of the third light spot in the calculation target area.

2. A light spot centroid position acquisition method according to claim 1,
   wherein, at the second step, when v represents a vector from the known centroid position or the known intensity peak position of the first light spot to the known centroid position or the known intensity peak position of the second light spot, the method sets the calculation target area to an area whose center is a position acquired by adding the vector v to the estimated position of the third light spot.

3. A light spot centroid position acquisition method according to claim 1, wherein the method (i) newly sets the calculation target area at the second step such that the centroid position of the third light spot calculated at the third step is located at a center of the newly set calculation target area and (ii) recalculates the centroid position of the third light spot in the newly set calculation target area.

4. A light spot centroid position acquisition method according to any one of claims 1 to 3, wherein the method (i) sets a microlens adjacent to the third microlens for which the centroid position is acquired as a new third microlens and (ii) sequentially repeats a step of acquiring the centroid position for the new third microlens by performing the first to third steps to acquire the centroid positions for the multiple microlenses.

5. A wavefront measurement method **characterized by** comprising:

performing a light spot centroid position acquisition method according to any one of claims 1 to 4; and measuring the wavefront by using the centroid positions acquired by the light spot centroid position acquisition method.

6. A wavefront measurement apparatus **characterized by** comprising:

a wavefront sensor (3) including an optical detector and multiple microlenses arranged mutually coplanarly; and a processor (5) configured to perform a light spot centroid position acquisition process using a light spot centroid position acquisition method according to any one of claims 1 to 4 and configured to measure the wavefront by using the centroid positions acquired by the light spot centroid position acquisition method.

7. A method of manufacturing an optical element (12), the method **characterized by** comprising:

measuring a shape of the optical element by using a wavefront measurement method according to claim 5 or by using a wavefront measurement apparatus according to claim 6; and shaping the optical element by using a result of the measurement.

8. A light spot centroid position acquisition program to cause a computer (8) to perform a process for acquiring a centroid position of each of light spots formed on an optical detector (2) by multiple microlenses (la) arranged mutually coplanarly in a wavefront sensor (3) to be used to measure a wavefront of light, wherein the process is **characterized by** comprising:

a first step (A-3) of estimating, by using known centroid positions or known intensity peak positions of a first light spot (a) and a second light spot (b) respectively formed by a first microlens (A) and a second microlens (B) in the multiple microlenses, a position of a third light spot (c) formed by a third microlens (C) in the multiple microlenses, the first to third microlenses being collinearly arranged; a second step (A-4) of setting, by using the estimated position of the third light spot, a calculation target area of a centroid position of the third light spot on the optical detector; and a third step (A-5) of calculating the centroid position of the third light spot in the calculation target area.

FIG. 1

FIG. 2

$$A \quad B \quad C$$

$$(i-2, j) \quad (i-1, j) \quad (i, j)$$

$$G_{0x}(i-2, j) \quad G_{0x}(i-1, j) \quad G_{0x}(i, j)$$

$$G_x(i-2, j) \quad G_x(i-1, j)$$

$$2\{G_x(i-1, j) - G_{0x}(i-1, j)\} - \{G_x(i-2, j) - G_{0x}(i-2, j)\}$$

$$g_x{}'(i, j)$$

CENTROID
CALCULATION AREA

## FIG. 3

START

A-1 | DETECT CENTROID POSITIONOF FIRST LIGHT SPOT

A-2 | SELECT TARGET MICROLENS

A-3 | PRIMARILY ESTIMATE POSITION OF TARGET LIGHT SPOT

A-4 | SET CENTROID CALCULATION AREA

A-5 | CALCULATE CENTROID POSITION OF TARGET LIGHT SPOT

A-6 | HAS CALCULATION OF ALL LIGHT SPOT CENTROID POSITIONS COMPLETED?

NO

YES

END

FIG. 4

**FIG. 5**

**FIG. 6**

**FIG. 7**

Europäisches
Patentamt

European
Patent Office

Office européen
des brevets

# EUROPEAN SEARCH REPORT

Application Number

EP 15 00 2338

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 750 957 B1 (LEVECQ XAVIER JEAN-FRANCOIS [FR] ET AL) 15 June 2004 (2004-06-15) | 1-6,8 | INV. G01J1/42 G01J9/00 G01M11/02 G03F7/20 |
| Y | * column 4, line 8 - line 42; figure 1 * | 7 | |
| Y | US 2013/235472 A1 (FURUKAWA YASUNORI [JP] ET AL) 12 September 2013 (2013-09-12) * figure 1 * | 7 | |
| A | ROGGEMANN AND AL M C: "Algorithm to increase the largest aberration that can be reconstructed from Hartmann sensor measurements", APPLIED OPTICS, OPTICAL SOCIETY OF AMERICA, WASHINGTON, DC; US, vol. 37, no. 20, 10 July 1998 (1998-07-10) , pages 4321-4329, XP002112722, ISSN: 0003-6935 * the whole document * | 1-8 | |
| A | JUNWON LEE ET AL: "Sorting method to extend the dynamic range of the Shack-Hartmann wave-front sensor", APPLIED OPTICS, vol. 44, no. 23, 10 August 2005 (2005-08-10), pages 4838-45, XP055234202, WASHINGTON, DC; US ISSN: 0003-6935, DOI: 10.1364/AO.44.004838 * the whole document * | 1-8 | TECHNICAL FIELDS SEARCHED (IPC) G01J G01M G03F |

The present search report has been drawn up for all claims

| Place of search | Date of completion of the search | Examiner |
|---|---|---|
| Munich | 22 December 2015 | Rödig, Christoph |

EPO FORM 1503 03.82 (P04C01)

**ANNEX TO THE EUROPEAN SEARCH REPORT
ON EUROPEAN PATENT APPLICATION NO.**                    EP 15 00 2338

This annex lists the patent family members relating to the patent documents cited in the above-mentioned European search report.
The members are as contained in the European Patent Office EDP file on
The European Patent Office is in no way liable for these particulars which are merely given for the purpose of information.

22-12-2015

| Patent document cited in search report | | Publication date | Patent family member(s) | | Publication date |
|---|---|---|---|---|---|
| US 6750957 | B1 | 15-06-2004 | AT | 245808 T | 15-08-2003 |
| | | | AU | 3053600 A | 01-08-2000 |
| | | | DE | 60004020 D1 | 28-08-2003 |
| | | | DE | 60004020 T2 | 03-06-2004 |
| | | | EP | 1157261 A2 | 28-11-2001 |
| | | | FR | 2788597 A1 | 21-07-2000 |
| | | | JP | 2002535608 A | 22-10-2002 |
| | | | US | 6750957 B1 | 15-06-2004 |
| | | | WO | 0042401 A2 | 20-07-2000 |
| US 2013235472 | A1 | 12-09-2013 | DE | 102013203883 A1 | 12-09-2013 |
| | | | JP | 2013186017 A | 19-09-2013 |
| | | | US | 2013235472 A1 | 12-09-2013 |

EPO FORM P0459

For more details about this annex : see Official Journal of the European Patent Office, No. 12/82

**EP 2 982 946 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010185803 A
- JP 2002535608 W
- JP 2002535608 T

**Non-patent literature cited in the description**

- **W.H.SOUTHWELL.** Wave-front estimation from wave-front slope measurement. *J.Opt.Soc.Am.,* 1980, vol. 70, 998-1006